Europäisches Patentamt

European Patent Office

Office européen des brevets

(11) Veröffentlichungsnummer: **0 198 357**
**B1**

(12) **EUROPÄISCHE PATENTSCHRIFT**

(45) Veröffentlichungstag der Patentschrift:
08.11.89

(51) Int. Cl.⁴: **G 03 F 7/10**

(21) Anmeldenummer: **86104613.4**

(22) Anmeldetag: **04.04.86**

(54) **Stabilisierte Lösungen strahlungsvernetzbarer Polymerstufen hochwärmebeständiger Polymere.**

(30) Priorität: **17.04.85 DE 3513779**

(43) Veröffentlichungstag der Anmeldung:
**22.10.86 Patentblatt 86/43**

(45) Bekanntmachung des Hinweises auf die Patenterteilung:
**08.11.89 Patentblatt 89/45**

(84) Benannte Vertragsstaaten:
**AT CH DE FR GB IT LI NL**

(56) Entgegenhaltungen:
**DE-A- 2 513 142
DE-A- 2 749 639
DE-A- 3 241 980
FR-A- 1 532 373
US-A- 2 691 584
US-A- 3 776 736
US-A- 3 817 850
US-A- 3 932 346
US-A- 4 501 689**

**RESEARCH DISCLOSURE, Nr. 163, November 1977,
Seite 62, Nr. 16346, Industrial Opportunities Ltd, GB;
M.S. KAPLAN: "Phenolic sulfide stabilizers for litho
plates"**

(73) Patentinhaber: **CIBA-GEIGY AG, Klybeckstrasse 141,
CH-4002 Basel (CH)**

(72) Erfinder: **Merrem, Hans-Joachim, Dr.,
Donnersbergstrasse 6, D-6104 Seeheim (DE)**
Erfinder: **Klug, Rudolf, Dr., Grünewaldstrasse 25,
D-8750 Aschaffenburg (DE)**
Erfinder: **Binder, Horst, Händelstrasse 3-5,
D-6840 Lampertheim (DE)**

## Beschreibung

Die Erfindung betrifft stabilisierte Lösungen von strahlungsvernetzbaren Polymervorstufen hochwärmebeständiger Polymere.

Bei den Polymervorstufen handelt es sich hier um lösliche Polyadditions- oder Polykondensationsprodukte aus carbocyclischen oder heterocyclischen Verbindungen mit zwei zu Polyadditions- oder Polykondensationsreaktionen befähigten funktionellen Gruppen sowie mit teilweise dazu in ortho- oder peri-Stellung esterartig an Carboxylgruppen gebundenen strahlungsreaktiven Resten und mit diesen funktionellen Gruppen umsetzbare Diamine, Diisocyanate, bis-Säurechloride oder Dicarbonsäuren, die mindestens ein cyclisches Strukturelement enthalten. Die vielfältigen strahlungsreaktiven Reste, die diese löslichen polymeren Vorstufen enthalten können, sind beispielsweise aus den Patentschriften DE-PS 2 308 830/USP 3 975 512, DE-PS 2 437 348/ USP Re. 39 186, DE-PS 2 437 368/USP 4 045 223 und DE-PS 2 437 422/USP 4 088 489 sowie den deutschen Patentanmeldungen DE-OS 3 227 584 und DE-OS 3 233 912 bekannt.

In der Regel sind dies strahlungsvernetzbare ungesättigte Gruppen, die vinylische oder allylische Doppelbindungen enthalten. Insbesondere sind es esterartig an Carboxylgruppen gebundene Oxyallyl-, Oxyalkylacrylat- und Oxyalkylmethacrylat-Gruppen, wie etwa 2-Oxyethylacrylat- oder -methacrylat-Gruppen, ferner Allyloxy- und/oder Allylthiogruppen enthaltende Estergruppen.

Diese in einer Vielzahl von organischen Lösungsmitteln gut löslichen, strahlungsvernetzbaren Polymervorstufen lassen sich sehr vorteilhaft zu Fotolacken verarbeiten, die in großem Umfang bei der Herstellung von elektrischen und elektronischen Bauelementen verwendet werden, etwa als Fotoresists oder in Form von Isolations-, Passivierungs- oder Schutzschichten bei der Halbleiterfertigung, oder zur Erzeugung von Orientierungsschichten in der Flüssigkristall-Display-Fertigung oder bei der Herstellung von Ätz- und Galvanik-Reserven sowie von Druckplatten. Hierzu werden derartige Fotolacke auf entsprechende Substrate in Form einer Schicht aufgetragen, die Schicht wird getrocknet und dann vollständig oder durch eine Negativvorlage bildmäßig belichtet. An den bestrahlten Stellen findet dadurch eine Vernetzung statt, die die Löslichkeit des aufgetragenen Materials dort drastisch verringert. Nicht bestrahlte Schichtteile können dann mit Hilfe eines Entwicklers vom Substrat abgelöst werden; die verbleibenden Schichtteile bzw. Reliefstrukturen lassen sich durch Tempern in hochwärmebeständige Polymere überführen, die Temperaturen von 250 - 400°C ohne nachteilige Auswirkung auf die Beschichtung oder die Kantenschärfe und Auflösung der Bildmuster überstehen.

Von Lösungen dieser Polymervorstufen, wie sie etwa in Form von Fotolacken für die vorgenannten Zwecke vorliegen können, ist allerdings bekannt, daß die zu spontanen, nicht reproduzierbaren und auch nicht wieder rückgängig machbaren Viskositätserhöhungen neigen. Häufig schon innerhalb weniger Tage, manchmal erst im Verlauf von einigen Wochen gelieren diese Lösungen und sind für den weiteren Gebrauch dann nicht mehr geeignet. Fotolacke auf Basis dieser Polymervorstufen sind aufgrund dieses spontanen, unvorhersehbaren und unkontrollierten Verhaltens kaum oder nur bedingt lager- und einsatzfähig.

Es gilt als sicher, daß diese Viskositätsveränderungen durch spontane, nicht fotoinduzierte Vernetzung der ungesättigten strahlungsreaktiven Gruppen der Polymervorstufen bewirkt werden.

Es bestand somit die Aufgabe, Lösungen dieser strahlungsvernetzbaren Polymervorstufen hochwärmebeständiger Polymere wirksam gegen ein Gelieren durch vorzeitige Vernetzung zu stabilisieren und insbesondere hierfür geeignete Stabilisatoren aufzufinden.

Es zeigte sich, daß dem Fachmann zur Stabilisierung von Acrylat-, Vinyl- und Allylverbindungen geläufige Polymerisationsinhibitoren, wie beispielsweise Hydrochinon oder etwa Schwermetalle wie Kupfer, im Fall der vorliegenden strahlungsvernetzbaren Polymervorstufen keine oder keine ausreichende Stabilisierung bewirken oder gar für die Anwendung in Fotolacken für die Halbleiterfertigung völlig ungeeignet sind.

Überraschenderweise wurde jedoch nun gefunden, daß man eine wirksame Stabilisierung von Lösungen strahlungsvernetzbarer Polymervorstufen hochwärmebeständiger Polymere gegen ein Gelieren durch vorzeitige Vernetzung erreicht, wenn man diesen Lösungen geringe Mengen an Chelatkomplexbildnern der Gruppe Ethylendiamin, Nitrilotriessigsäure, Ethylendiamintetraessigsäure, 1,2--Cyclohexylendiamintetraessigsäure, Diethylentriaminpentaessigsäure, Bis-(2-aminoethyl)-glycol--ether-N,N,N',N'-tetraessigsäure und 8-Hydroxychinolin als Stabilisatoren zusetzt.

Gegenstand der Erfindung sind somit stabilisierte Lösungen von strahlungsvernetzbaren Polymervorstufen hochwärmebeständiger Polymere, die als Stabilisatoren diese Chelatkomplexbildner enthalten.

Gegenstand der Erfindung ist weiterhin die Verwendung der genannten Chelatkomplexbildner zur Stabilisierung von Lösungen strahlungsvernetzbarer Polymervorstufen hochwärmebeständiger Polymere gegen ein Gelieren durch vorzeitige Vernetzung.

Gegenstand der Erfindung ist insbesondere auch die Verwendung der genannten Chelatkomplexbildner als Stabilisatoren in Fotolacken auf Basis von strahlungsvernetzbaren Polymervorstufen hochwärmebeständiger Polymere zur Ausbildung von Reliefstrukturen.

Die erfindungsgemäß als Stabilisatoren zu den Lösungen der strahlungsvernetzbaren Polymervorstufen zuzusetzenden Chelatkomplexbildner sind an sich bekannt, etwa aus dem Bereich der chemischen Analytik, insbesondere der Komplexometrie. Geeignet für den erfindungsgemäßen Zweck sind im Prinzip alle 2-oder mehrzähnigen Chelatkomplexbildner, die in der Lage sind, mit Metallionen stabile Chelatkomplexe zu bilden. Vorzugsweise werden die kommerziell leicht erhältlichen Komplexbildner Ethylendiamin, Nitrilotriessigsäure, Ethylendiamintetraessigsäure, 1,2-Cyclohexylendiamintetraessigsäure,

Diethylentriaminpentaessigsäure, Bis-(2-aminoethyl)-glycolether-N,N,N',N'-tetraessigsäure und 8--Hydroxychinolin verwendet. Besonders bevorzugt sind Ethylendiamintetraessigsäure und 8-Hydroxychinolin.

Durch diese Chelatkomplexbildner werden die Lö-sungen fotovernetzbarer Polymervorstufen hoch-wärmebeständiger Polymere äußerst wirksam ge-gen eine spontane, nicht fotoinduzierte Vernetzung stabilisiert. Derartige Lösungen zeigen über Wochen hinweg keinerlei Neigung zu unkontrollierten Viskositätsveränderungen, sind somit etwa in Form von Fotolacken beliebige Zeit lager- und gebrauchsfähig. Weiterhin bewirken diese Stabilisatoren keinen negativen Einfluß auf die spätere Fotovernetzung von mit solchen Fotolacken hergestellten Beschichtungen, beispielsweise Fotoresistreliefstrukturen bei der Halbleiterfertigung.

Der mengenmäßige Zusatz der erfindungsgemäßen Stabilisatoren zu den Polymerlösungen ist in weiten Bereichen unkritisch. Schon geringe Mengen, etwa im Bereich von 0,1-100 ppm, sind für eine wirksame Inhibierung des Gelierens ausreichend. Vorzugsweise werden die Chelatkomplexbildner den Lösungen der fotovernetzbaren Polymervorstufen in einem Anteil von 10-50 ppm zugesetzt, bezogen auf die Polymerlösungen. Die Herstellung solcher erfindungsgemäß stabilisierter Lösungen erfolgt durch einfache Zugabe der entsprechenden Komplexbildner in der geeigneten Menge zu den Polymerlösungen. Im übrigen erfolgt die Herstellung der Polymerlösungen bzw. derartiger Fotolacke in völlig konventioneller Weise, etwa wie in den eingangs beispielhaft zitierten Druckschriften angegeben.

Prinzipiell sind alle in organischen Lösungsmitteln löslichen Polymervorstufen hochwärmebeständiger Polymere, die ungesättigte strahlungsreaktive Gruppen tragen, erfindungsgemäß gegen eine vorzeitige Vernetzung stabilisierbar. Die eine spontane Vernetzung inhibierende Wirkung der Stabilisatoren ist unabhängig von der jeweiligen Natur der Polymergrundkörper, da die Vernetzung über die ungesättigten strahlungsreaktiven Gruppen erfolgt.

Die Erfindung richtet sich vornehmlich auf die Stabilisierung von Polymervorstufen, wie sie in den eingangs zitierten Druckschriften offenbart sind. Hiervon bevorzugte polymere Vorstufen sind Polykondensate aus Pyromellithsäure, die zwei esterartig an Carboxylgruppen gebundene strahlungsreaktive Reste trägt, und einem mindestens ein cyclisches Strukturelement enthaltenden Diamin, wie beispielsweise 4,4'-Diaminodiphenylether, 4,4'Diamino-diphenylmethan, 4,4-Diaminodiphenylsulfon und 2,4-Diaminopyridin. Besonders bevorzugt sind Polykondensate von Pyromellithsäure, die zwei mit 2-Hydroxyethylmethacrylat und/oder mit Glycolmonoallylether veresterte Carboxylgruppen aufweist (gemäß DE-PS 2 437 348 bzw. DE-OS 3 227 584) mit 4,4'-Diaminodiphenylether. Weiterhin lassen sich erfindungsgemäß alle aus solchen Polymervorstufen in üblicher Weise hergestellten Fotolacke stabilisieren. Die Wahl der Lösungsmittel und das Vorhandensein von in der Technologie der Fotolacke gängigen Zusätzen und Hilfsstoffen, insbesondere von Substanzen, die die Strahlungsempfindlichkeit der Lacke erhöhen, wie copolymerisierbare Mono-mere, Fotosensibilisatoren und Fotoinitiatoren, ha-ben keinen Einfluß auf die stabilisierende Wirkung der Chelatkomplexbildner.

Als Lösungsmittel, die die löslichen polymeren Vorstufen und die weiteren Bestandteile der Fotolacke lösen können, eignen sich beispielsweise Ethylenglykol, Glykolether, wie Glykolmonomethylether, Glykoldimethylether und Glykolmonoethylether; ali-phatische Ester wie Ethylacetat, Hydroxyethylace-tat, Alkoxyethylacetat, n-Butylacetat oder Amylacetat; Ether wie Dioxan; Ketone wie Methylethylketon, Methyl-iso-butylketon, Cyclopentanon und Cyclohexanon; Dimethylformamid, Dimethylacetamid, Hexamethylphosphorsäuretriamid, N-Methylpyrroli-don, Butyrolacton, Tetrahydrofuran und Mischun-gen solcher Lösungsmittel. In Fotolacken enthalten diese Lösungen in der Regel 1 bis 60%, vorzugsweise 5 bis 50% an Feststoffen.

Die Anwendung der erfindungsgemäß stabilisierten Fotolacke, beispielsweise in der Halbleiterfertigung, erfolgt in völlig analoger Weise, wie es von solchen gemäß dem Stand der Technik bekannt ist.

Gemäß der Erfindung können somit der Fachwelt qualitativ besonders hochwertige Fotolacke, die durch den Zusatz von Chelatkomplexbildnern als Stabilisatoren lange lager- und gebrauchsfähig bleiben, angeboten werden.

*Beispiele*

1. Strahlungsvernetzbare polymere Vorstufe

Eine strahlungsvernetzbare polymere Vorstufe wird gemäß DE-PS 2 437 348 erhalten durch Umsetzung von Pyromellithsäuredianhydrid mit 2-Hydroxyethylmethacrylat und anschließende Kondensation mit 4,4'-Diaminodiphenylether in Gegenwart von Thionylchlorid.

2. Viskositätsverhalten von Lösungen bei Lagerung
   bei +4°C.

Es wurden 8 jeweils etwa 45 Gew.-% einer polymeren Vorstufe nach Beispiel 1 enthaltende Lösungen in N-Methylpyrrolidon hergestellt. 4 der Probelösungen wurden mit jeweils 50 ppm eines Chelatkomplexbildners versetzt, die anderen erhielten keinen Stabilisator. Die Viskositäten der Lösungen wurden bestimmt und nach 14 Tagen Lagerung bei einer Temperatur von +4°C erneut gemessen.

Die nachfolgende Tabelle zeigt das Viskositätsver-halten:

| Probe | | Ausgangs-viskosität (mm²/s) | Viskosität nach 14 Tagen (mm²/s) | Anstieg % |
|---|---|---|---|---|
| 1 | mit Stabilisator Ethylendiamintetraessigsäure | 2659 | 2659 | 0 |
| 2 | » | 2727 | 2741 | 0,5 |
| 3 | » | 2812 | 2812 | 0 |
| 4 | » | 2914 | 2925 | 0,4 |
| 5 | ohne Stabilisator | 2644 | 2910 | 10,0 |
| 6 | » | 2617 | 3005 | 14,8 |
| 7 | » | 2639 | 2995 | 13,5 |
| 8 | » | 2747 | 3595 | 30,8 |

Im Rahmen der Meßgenauigkeit blieben die Viskositäten der mit dem Komplexbildner versetzten Lösungen unverändert. Die nicht stabilisierten Lösungen zeigten jedoch Viskositätszunahmen von 10 bis 30%.

3. Geliertest bei einer Lagertemperatur von 42°C.

Von einer 45 Gew.-%igen Lösung einer polymeren Vorstufe nach Beispiel 1 wurden 55 Proben mit 50 ppm des Chelatkomplexbildners Ethylendiamintetraessigsäure versetzt und zusammen mit 17 Vergleichsproben ohne Stabilisator bei einer Temperatur von 42°C gelagert.

Nach 3 bis 8 Tagen waren alle 17 Vergleichsproben geliert.

Die 55 stabilisierten Proben zeigten auch nach 40 Tagen keine Veränderung.

**Patentansprüche**

1. Stabilisierte Lösungen von strahlungsvernetzbaren Polymervorstufen hochwärmebeständiger Polymere, dadurch gekennzeichnet, daß diese als Stabilisatoren Chelatkomplexbildner der Gruppe Ethylendiamin, Nitrilotriessigsäure, Ethylendiamintetraessigsäure, 1,2-Cyclohexylendiamintetraessigsäure, Diethylentriaminpentaessigsäure, Bis-(2--aminoethyl)-glycolether-N,N,N',N'-tetraessigsäure und 8-Hydroxychinolin enthalten.

2. Stabilisierte Lösungen nach Anspruch 1, dadurch gekennzeichnet, daß sie 0,1-100 ppm, vorzugsweise 10-50 ppm der Chelatkomplexbildner enthalten.

3. Verwendung von Chelatkomplexbildnern der Gruppe Ethylendiamin, Nitrilotriessigsäure, Ethylendiamintetraessigsäure, 1,2-Cyclohexylendiamintetraessigsäure, Diethylentriaminpentaessigsäure, Bis-(2-aminoethyl)-glycolether-N,N,N',N'-tetraessigsäure und 8-Hydroxychinolin zur Stabilisierung von Lösungen strahlungsvernetzbarer Polymervorstufen hochwärmebeständiger Polymere gegen ein Gelieren durch vorzeitige Vernetzung.

4. Verwendung von Chelatkomplexbildnern der Gruppe Ethylendiamin, Nitrilotriessigsäure, Ethylendiamintetraessigsäure, 1,2-Cyclohexylendiamintetraessigsäure, Diethylentriaminpentaessigsäure, Bis-(2-aminoethyl)-glycolether-N,N,N',N'-tetraessigsäure und 8-Hydroxychinolin zur Stabilisierung von Fotolacken auf Basis von strahlungsvernetzbaren Polymervorstufen hochwärmebeständiger Polymere.

**Claims**

1. A stablized solution of a radiator-crosslinkable polymer precursor of a highly heat-resistant polymer, which contains as stabilizer a chelate complexformer from the group comprising ethylenediamine, nitrilotriacetic acid, ethylenediaminetetraacetic acid, 1,2-cyclohexylenediaminetetraacetic acid, diethylenetriaminepentaacetic acid, (3,6-dioxa)-octylenediamine-N,N,N',N'-tetraacetic acid or 8-hydroxyquinoline.

2. A stablized solution according to Claim 1, which contains 0.1-100 ppm, preferably 10-50 ppm of the chelate complex-former.

3. Use of a chelate complex-former from the group comprising ethylenediamine , nitrilotriacetic acid, ethylenediaminetetraacetic acid, 1,2-cyclohexylenediaminetetraacetic acid, diethylenetriaminepentaacetic acid, (3,6-dioxa)-octylenediamine-N,N,N',N'-tetraacetic acid or 8-hydroxyquinoline for stabilizing a solution of a radiation-crosslinkable polymer precursor of a highly heat-resistant polymer against gelling through premature crosslinking.

4. Use of a chelate complex-former from the group comprising ethylenediamine, nitrilotriacetic acid, ethylenediaminetetraacetic acid, 1,2-cyclohexylenediaminetetraacetic acid, diethylenetriaminepentaacetic acid, (3,6-dioxa)-octylenediamine-N,N,N',N'-tetraacetic acid or 8-hydroxyquinoline for stabilizing a photosensitive resist lacquer based on a radiation-crosslinkable polymer precursor of a highly heat-resistant polymer.

**Revendications**

1. Solutions stabilisées de précurseurs polymères radioréticulables qui doivent donner des polymères ayant une grande résistance à la chaleur, solutions caractérisées en ce qu'elles contiennent, comme stabilisants, des générateurs de chélates complexes appartenant à l'ensemble constitué par l'éthylène-diamine, l'acide nitrilo-triacétique, l'acide éthylène-diamine-tétracétique, l'acide cyclohexylène-1,2 diamine-tétracétique, l'acide diéthylène-triamine-pentacétique, l'acide dioxa-3,6 octanediamine-1,8 N,N,N',N'-tétracétique et l'hydroxy-8 quinoléine.

2. Solutions stabilisées selon la revendication 1, caractérisées en ce qu'elles contiennent de 0,1 à 100 ppm des générateurs de chélates complexes, de préférence de 10 à 50 ppm.

3. Application de générateurs de chélates complexes pris dans l'ensemble constitué par l'éthylène-diamine, l'acide nitrilo-triacétique, l'acide éthylène-diamine-tétracétique, l'acide cyclohexylène--1,2 diamine-tétracétique, l'acide diéthylène-triamine-pentacétique l'acide dioxa-3,6 octane-diamine-1,8 N,N,N',N'-tetracétique et l'hydroxy-8 quinoléine à la stabilisation, contre une gélification par reticulation prématurée, de solutions de précurseurs polymères radioréticulables devant donner des polymères très stables à la chaleur.

4. Application de générateurs de chélates complexes appartenant à l'ensemble constitué par l'éthylène-diamine, l'acide nitrilo-triacétique, l'acide éthylène-diamine-tétracétique l'acide cyclohexylène-1,2 diamine-tétracétique, l'acide diéthylène-triamine-pentacétique, l'acide dioxa-3,6 octane-diamine-1,8 N,N,N',N'-tétracétique et l'hydroxy-8 quinoléine à la stabilisation de photolaques à base de précurseurs polymères radioréticulables devant donner des polmères très stables à la chaleur.